Europäisches Patentamt

European Patent Office

Office européen des brevets

(11) Publication number: **0 002 387**
**A1**

(12) **EUROPEAN PATENT APPLICATION**

(21) Application number: **78300741.2**

(22) Date of filing: **05.12.78**

(51) Int. Cl.²: **G 08 B 21/00**
**G 01 R 31/00**

(30) Priority: **05.12.77 GB 50482/77**

(43) Date of publication of application:
**13.06.79 Bulletin 79/12**

(84) Designated contracting states:
**CH DE FR SE**

(71) Applicant: **The General Electric Company Limited**
**1 Stanhope Gate**
**London W1A 1EH(GB)**

(72) Inventor: **Elkateb, Makeen Mohammed**
**11 Somerville Square**
**Moss Pit Stafford ST17 9JU(GB)**

(72) Inventor: **Thomas, Alan John**
**'Niarbyl' Raikeswood Cresent**
**Skipton Yorkshire(GB)**

(74) Representative: **Pope, Michael Bertram Wingate**
**Central Patent Department The General Electric**
**Company Limited Hirst Research Centre**
**Wembley Middlesex HA9 7PP(GB)**

(54) **Electric power system fault warning arrangements.**

(57) A fault warning arrangement for use in an electric power system, wherein the system includes warning means (10, 11) for producing a first signal when the value of the leakage current in an insulator arrangement (5, 6), e.g. supporting a power line (3), of the system exceeds a first threshold value. The warning means may be arranged to detect the passing of threshold values by values of insulator leakage current by detecting the passing of threshold values by values of total insulator currents.

Fig.2.

Croydon Printing Company Ltd.

This application relates to electric power systems and more particularly to the warning of faults in such systems.

In many cases the insulator contamination of high voltage systems represents the main source of troubles in producing loss of power due to faults. Systems faults due to contamination are usually attributed to natural dust or, in industrial areas, to polluted atmospheric conditions. Whilst the latter cause can be, and recently in some countries partially has been, alleviated by the limitation of. such pollution, the occurrence of natural dust is mainly a function of local soil conductivity. Also, in areas where fog occurs, the accumulated dust on the surface of insulators becomes a conducting material. Even in countries where dust contamination is not such a problem, the combination of humidity and salt content in coastal areas may cause problems comparable with those arising from dust deposits from conductive soils.

The invention relates to any electric power system including insulators exposed to pollution but has especial application to overhead electric power transmission systems. For such systems techniques have been developed to identify a faulted tower (i.e. a tower on which a supported power line has developed a fault due to insulator contamination) from a knowledge of the post fault voltages and currents at the switching station feeding the faulted line. The conventional technique is to obtain the current and voltage waveforms from fault recorders at the switching stations. With the superposition of the waveforms from the switching stations feeding the line and the utilisation of special mathematical techniques it is possible to locate the faulted tower, but with an error that may cover between three and ten towers depending on the accuracy of the fault recorders and the mathematical procedure.

However, due to the tediousness of the mathematical techniques involved, fault recorders are not often used as fault locators.

The locating of the faulted tower brings several advantages: firstly, the repetition of faults on the same tower may indicate that special attention is required in the form of frequent cleaning or the fitting of extra insulators; secondly, a tremendous saving of manpower is achieved in locating and performing the maintenance required; thirdly, important statistical data can be obtained for further transmission planning; and fourthly, useful information is provided in the case of malfunctioning of protective relays.

It is an object of the present invention to provide a fault warning arrangement for use in an electric power system in which the occurrence of a fault in an insulator arrangement of the system can be predicted and wherein the above disadvantages may be overcome.

The present invention provides a fault warning arrangement for use in an electric power system characterised by warning means for producing a first signal when the value of the leakage current in an insulator arrangement of the system exceeds a first threshold value.

Preferably said warning means also produces a second signal when the value of said insulator leakage current is below a second threshold value, said second signal being representative of the amount by which the value of said insulator leakage current is below said second threshold value.

0002387

-4-

Alternatively said warning means may also produce a second signal when the value of the neutral current of combined insulator leakage currents of all the insulator arrangements in a group, e.g. on the same single circuit tower or at a particular location, associated with different phases of the system exceeds a second threshold value, said second signal being representative of the amount by which the value of said neutral current exceeds said second threshold value.

Preferably said warning means includes encoding means so arranged that said warning means produces an encoded said first signal or an encoded said first signal and an encoded said second signal.

It will be appreciated that said warning means may be arranged to produce a signal indicative of the passing of a threshold value by the value of the insulator leakage current of any one of a plurality of insulator arrangements. In this case it will be appreciated that a single common encoding means may be used.

Preferably there is associated with a group of one or more of said warning means transmitting means for transmitting a signal produced by any one of the warning means of said group to a switching station of the system.

Preferably the signals produced by the or each warning means are optical signals, and preferably the optical signals are transmitted to the switching station via an optical fibre. The optical fibre may be arranged to be located in an earth conductor of the system, within the conductors of a power line of said system, within a bundle of conductors of said system, or, in an overhead transmission system where the towers of the system can safely support the extra load, suspended in catenaries from an earth wire of said system.

Preferably the or each warning means is arranged

-5-

to detect the passing of threshold values by values of insulator leakage current by detecting the passing of threshold values by values of total insulator current.

Preferably the or each warning means is arranged to be powered by insulator current.

The process of flashover in an insulator of an electric power system may take up to six hours to develop, depending on the atmosphere and the conductivity of the contamination, from the start of the process until the appearance of the arc. Also, the leakage current flowing across the insulator which culminates in a flashover, i.e. the appearance of an arc, increases in a substantially linear manner with time. Hence in accordance with the invention a detection of the increase in the leakage current across the insulator above a certain value can be used to predict the occurrence of a flashover.

However, apart from the leakage current flowing across the insulator there is also a substantially constant capacitive current flowing through it. The leakage current and the capacitive current, however, are in quadrature, since the capacitance of the insulator and the resistance of the contamination on the insulator may be considered as forming a parallel RC circuit. Hence, since the pre-flashover capacitive current is substantially constant, a detection of the increase in the resultant of the leakage current and the capacitive current, i.e. the total insulator current, above a certain value can, in accordance with the invention, be used to predict the occurrence of a flashover.

Also, in the instance of a downed conductor, broken conductor or other low insulation fault the voltage across the insulators of the conductor, and hence the total insulator current, falls to a minimum at the insulators immediately adjacent the fault.

-6-

Hence a detection of the decrease in the insulator leakage current below a certain value can be used to locate the position of the fault.

In order that the invention may be better understood, there will now be described, by way of example only, part of an overhead electric power transmission system according to the invention, with reference to the accompanying drawings, in which:--

Figure 1 shows schematically a suspension tower of the system;

Figure 2 shows schematically a tension tower of the system;

Figure 3 shows a more detailed representation of a first embodiment of a warning arrangement according to the invention suitable for use in the system;

Figure 4 shows a more detailed representation of a second embodiment, being a modification of the embodiment of Figure 3, of a warning arrangement according to the invention suitable for use in the system; and

Figure 5 shows a signal transmission and coding arrangement suitable for use in the system.

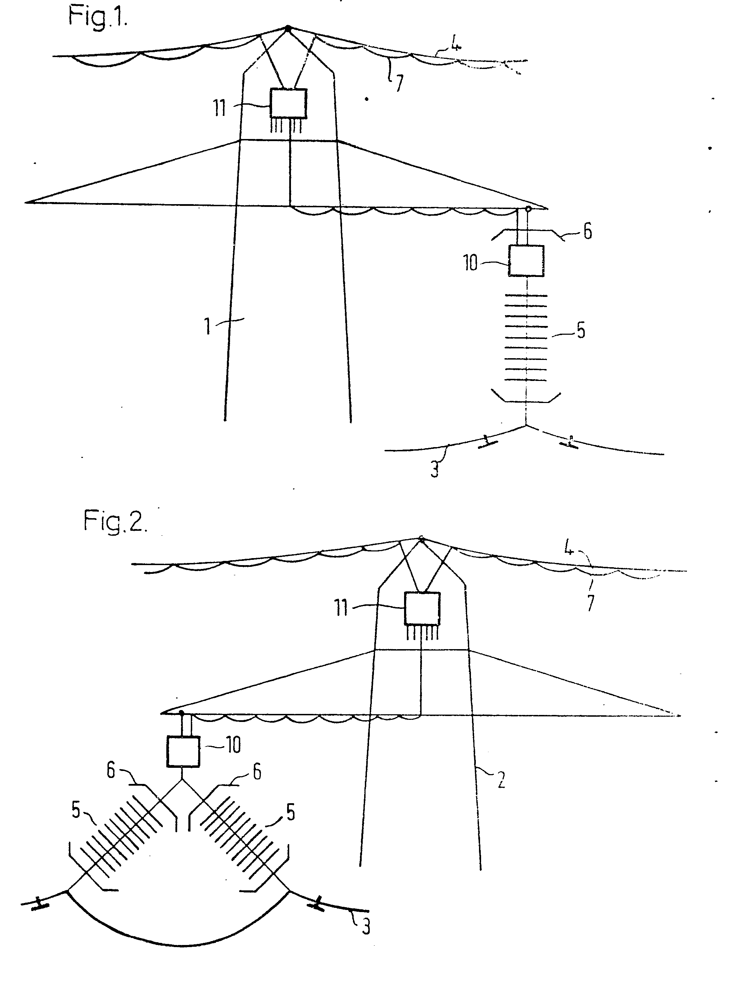

The system includes a number of suspension towers as in Figure 1 and a number of tension towers as in Figure 2 from which the power lines of the system are supported in conventional manner. On each tower is mounted a warning means which according to the first embodiment includes three detecting apparatuses 10 (only one of which is shown in Figures 1 and 2) and an encoding apparatus 11

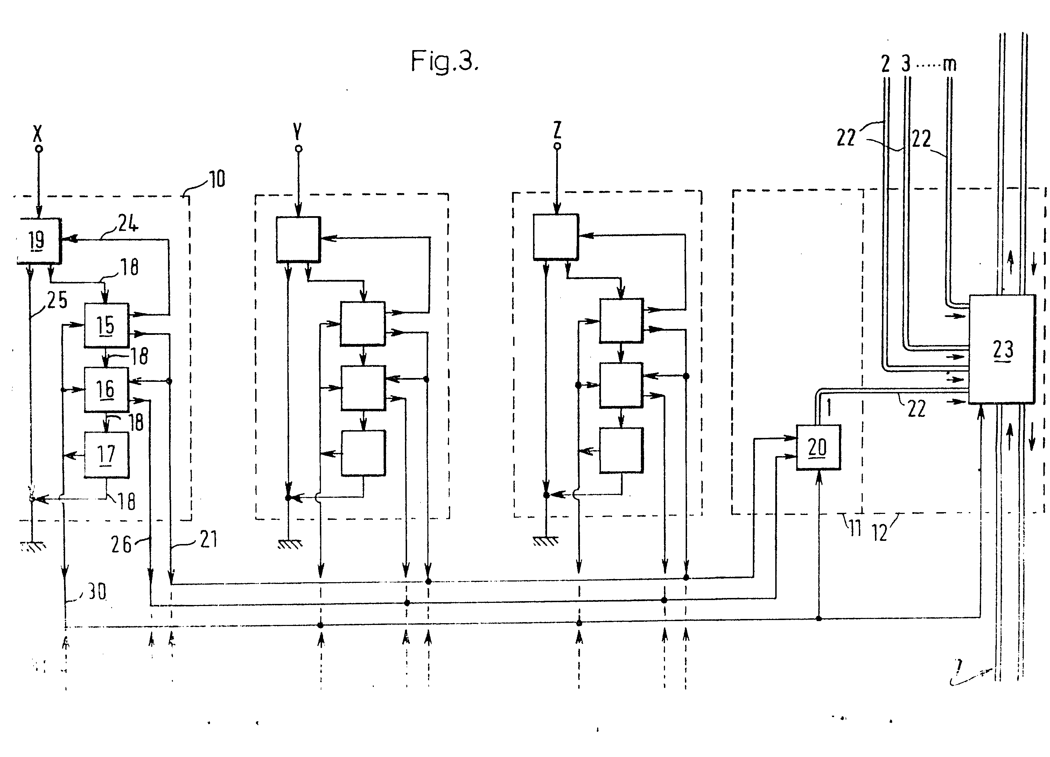

Referring firstly to figures 1 and 2, a detecting apparatus 10 (shown more fully in Figure 3), is associated with each insulator arrangement that supports a power line 3. Each detecting apparatus 10 may be connected between the earthy arcing horn 6 and the insulator 5 as shown in Figure 1, or between the earthy arcing horn 6 and earth as shown in Figure 2.    An encoding apparatus 11 is provided on each tower 1 or 2 and is preferably located high in the tower's structure conveniently near to the point where the overhead earth conductor 4 is secured to the tower. The overhead earth conductor is adapted to carry one or more optical fibres 7.

Referring now to Figure 3, the detecting apparatus 10 includes a first current level detector 15, a second current level detector 16 and a power source 17 all connected in series via path 18 through which normally the total current of the apparatus' associated insulator arrangement is arranged to pass. A changeover switch 19 adapted to give a visual indication of state is also provided.

The first current detector 15 detects when the value of the current passing through it exceeds a first predetermined value and upon detection produces a first signal which is applied via conductor 21 to an encoding means 20 which in turn produces a first predetermined optical signal that is conveyed via fibre 22 to an optical repeating means 23. Activation of the first current detector 15 de-activates the second current detector 16 and activates the changeover switch 19 via path 24 which causes the insulator current to flow along path 25 thus avoiding damage to detectors 15 and 16 and power source 17.

The second current detector 16 detects when the value of the current passing through it is below a second predetermined value and upon detection produces a second signal, representative of the amount by which the value of the current is below the second predetermined value, which is applied via conductor 26 to the encoding means 20 which in turn produces a second optical signal which is conveyed via fibre 22 to the optical repeating means 23.

A manual, automatic or remotely controlled device may be provided, although not shown here, to reset device 19 to direct the total insulator current back through path 18 when excess insulator current has subsided.

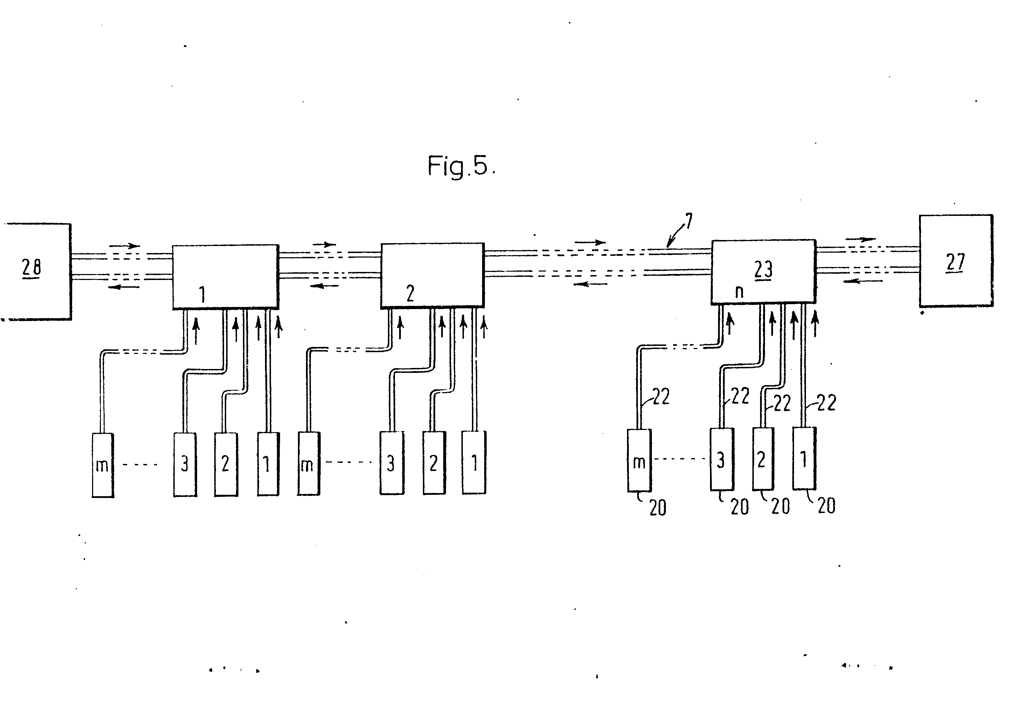

Referring now also to Figure 5 the encoding apparatuses 11 associated with the line 3 are divided into n groups each containing m encoding apparatuses. The encoded optical signals output from the m encoding apparatuses 11 of each group are conveyed through optical fibres 22 to a respective one of n repeater units 23. The signals received by each repeater unit are then transmitted via fibre optic cables 7 suspended in catenaries from the earth conductor 4 to switching stations 27 and 28 at either end of the line. At the switching stations a received signal is decoded, thereby locating the encoding means 20 which produced the signal. It will be appreciated that the optical fibres joining the two switching stations 27 and 28 may also be used to communicate between the two switching stations. It will thus be apparent that whilst encoding means 11 is fitted to each tower, only every $m$ th. tower has repeating apparatus 12 fitted thereto.

It will also be appreciated that in a double circuit transmission system, a first and a second current detector may, in accordance with the invention, be associated each with one of the two insulator arrangements of each circuit, either of the first current detectors or either of the second current detectors activating a common signal encoding means (indicated by paths 31 shown in Figure 3.).

Where technically necessary, elements of the system are supplied with power via conductor 30.

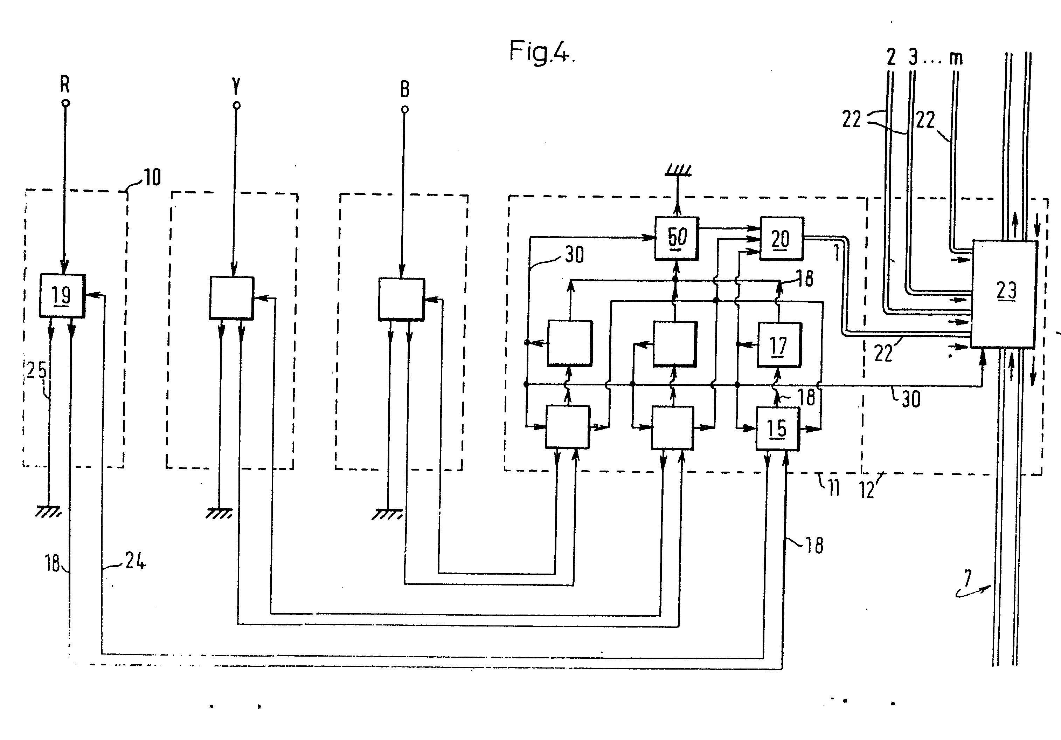

Referring now to Figure 4, according to a second embodiment of the invention, which embodiment is a modification of the first embodiment shown in

-9-

Figure 3, changeover apparatus 10 includes a changeover switch 19 adapted to give a visual indication of its state. Detecting and encoding apparatus 11 comprises three first level detectors 15, three power sources 17 and one second level detector 16. In general there may be as many first level detectors 15 as there are power sources 17, the number of each depending on the number of phases per tower, and there is at least one second level detector. For the purpose of illustration only a single circuit 3-phase tower arrangement is shown in Figure 4. The three sets of first detector 15 and power supply 17 receive the insulator currents R, Y, B which are later grouped to produce a neutral current. The neutral current is then passed through a single second level detector 50 before it reaches earth. Detectors 15 and 50 are activated when the current flowing through them exceeds a first or a second pre-determined value respectively. When detector 15 is activated, a first pre-determined signal is passed to encoder 20. When detector 50 is activated a second signal, representative of the amount by which the value of the neutral current exceeds said second predetermined value, is passed to encoder 20. Receipt of a first predetermined signal or second signal by encoder 20 causes a corresponding optical signal to be sent from encoder 20 to repeater 23 via fibre 22.

It will be understood that whilst the particular embodiment described above is an overhead electric power transmission system, the invention is applicable to any electric power system wherein components of the system, e.g. power lines, switchgear, transformers, etc., are insulated by arrangements exposed to pollution.

-10-

CLAIMS

1.    A fault warning arrangement for use in an electric power system characterised by warning means (10,11) for producing a first signal when the value of the leakage current in an insulator arrangement (5,6) of the system exceeds a first threshold value.

2.    An arrangement according to claim 1 characterised in that said warning means (10,11) also produces a second signal when the value of said insulator leakage current is below a second threshold value, said second signal being representative of the amount by which the value of said insulator leakage current is below said second threshold value.

3.    An arrangement according to claim 1 characterised in that said warning means also produces a second signal when the value of the neutral current comprising the combination of insulator leakage currents of all the insulator arrangements in a group associated with different phases of the system exceeds a second threshold value, said second signal being representative of the amount by which the value of said neutral current exceeds said second threshold value.

4.    An arrangement according to any preceding claim characterised in that said warning means includes encoding means (11) so arranged that said warning means produces an encoded said first signal or an encoded said first signal and an encoded said second signal.

5.    An arrangement according to any preceding claim characterised in that said warning means is arranged to produce a signal indicative of the passing of a threshold value by the value of the insulator leakage current of any one of a plurality of insulator arrangements.

6. An arrangement according to any preceding claim characterised in that there is associated with a group of one or more of said warning means transmitting means (7,22,23) for transmitting a signal produced by any one of the warning means of said group to a switching station of the system.

7. An arrangement according to any preceding claim characterised in that the signals produced by the or each warning means are optical signals.

8. An arrangement according to claim 7 characterised in that the optical signals are transmitted to a switching station of the system via an optical fibre (7,22).

9. An arrangement according to any preceding claim characterised in that the or each warning means is arranged to detect the passing of threshold values by values of insulator leakage current by detecting the passing of threshold values by values of total insulator current.

10. A fault warning arrangement according to any preceding claim wherein the system is an overhead electric power transmission system and the insulator arrangement supports a power line of the system.

1/4

Fig.1.

Fig.2.

000238

Fig.3.

Fig.4.

Fig.5.

## European Patent Office

## EUROPEAN SEARCH REPORT

Application number

EP 78 300 741.2

| | DOCUMENTS CONSIDERED TO BE RELEVANT | | CLASSIFICATION OF THE APPLICATION (Int. Cl.²) |
|---|---|---|---|
| Category | Citation of document with indication, where appropriate, of relevant passages | Relevant to claim | |
| | DE - C - 482 414 (SIEMENS-SCHU-CKERTWERKE) <br> * entirely * <br><br> -- <br><br> DE - C - 759 309 (SIEMENS-SCHU-CKERTWERKE) <br> * claims * <br><br> -- <br><br> US - A - 3 786 466 (HITACHI) <br> * abstract * <br><br> -- <br><br> DE - C - 399 959 (P. REINISCH) <br> * entirely * <br><br> -- <br><br> FR - A - 2 244 219 (D.L. SUSSMAN et al) <br> * fig. 1, claims * <br><br> ---- | 1 <br><br><br><br> 1 <br><br><br><br> 1 <br><br><br><br> 1,6, <br> 10 <br><br><br> 7,8 | G 08 B 21/00 <br> G 01 R 31/00 <br><br><br><br><br><br> **TECHNICAL FIELDS SEARCHED (Int.Cl.²)** <br><br> G 01 R 27/00 <br> G 01 R 31/00 <br> G 08 B 21/00 <br> G 08 B 25/00 <br> G 08 B 29/00 <br> H 01 H 83/10 <br> H 02 B 5/00 |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family. corresponding document

X | The present search report has been drawn up for all claims

| Place of search | Date of completion of the search | Examiner |
|---|---|---|
| Berlin | 07-03-1979 | BEYER |

EPO Form 1503.1  06.78